# EUROPÄISCHE PATENTANMELDUNG

(11) **EP 1 022 353 A1**
(43) Veröffentlichungstag der Anmeldung: **26.07.2000**
(21) Anmeldenummer: 99125084.6
(22) Anmeldetag: 16.12.1999
(51) Int. Cl.: C23C 16/16, C23C 18/08, B22F 1/02

(54) **Verfahren zur Herstellung metallbeschichteter Hartstoffe**

(30) Priorität: 21.01.1999 DE 19902000; 21.09.1999 DE 19945083
(71) Anmelder: BASF AKTIENGESELLSCHAFT, 67056 Ludwigshafen (DE)
(72) Erfinder: Schlegel, Reinhold, 67454 Hassloch (DE); Friedrich, Gabriele, Dr., 68165 Mannheim (DE); Remmele, Michael, 67240 Bobenheim-Roxheim (DE)

(57) **Zusammenfassung**

Metallbeschichtete Hartstoffe werden durch durch Zersetzung von Metallcarbonyl in Gegenwart von Hartstoffen hergestellt.

## Beschreibung

Die vorliegende Erfindung betrifft ein Verfahren zur Herstellung metallbeschichteter Hartstoffe.

Hartstoffe sind aufgrund ihrer hohen Härte wertvolle und begehrte Werkstoffe für Anwendungen, in denen die Härte des Werkstoffs von entscheidender Bedeutung ist. Hartstoffe werden beispielsweise dort eingesetzt, wo vergleichsweise kleine und harte einzelne Partikel benötigt werden, Diamanten typischerweise als Abtastspitze für elektromagnetische Aufzeichnungsmedien ("diamond recording stylus") oder Hartstoffe allgemein etwa in abrasiven oder spanenden Werkzeugen wie Schneid-, Bohr- Fräs- und Schleifwerkzeugen, wobei je nach Anwendungsfall das eigentliche Werkzeug als Ganzes oder lediglich seine entsprechenden am stärksten beanspruchten Teile aus Hartstoff oder aus in einer meist polymeren Matrix eingebetteten Hartstoffpartikeln hergestellt werden. Werkstücke aus derartigen matrixgebundenen Hartstoffen werden - wobei Form des Werkstücks und Material der Matrix dem jeweiligen Anwendungszweck entsprechend gewählt werden - beispielsweise durch Vermischen von Hartstoffpulver mit einem sinterfähigen Metall- oder Keramikpulver sowie gegebenenfalls Zusätzen und Hilfsstoffen, Formgebung und Sinterung oder durch Einbettung der Hartstoffpartikel in einen Kunststoff und Formgebung hergestellt. Derartige Verfahren sind bekannt.

Ein wichtiges Kriterium für die Brauchbarkeit solcher Werkstoffe ist die Haftung der Hartstoffpartikel in der Matrix. Eine häufig angewendete Methode zur Verbesserung dieser Haftung ist es, die Hartstoffpartikel bereits vor ihrer Einarbeitung in die Matrix mit einer haftvermittelnden Beschichtung versehen. Als Beschichtungsmaterialien werden üblicherweise Metalle, Legierungen oder Nichtmetalle verwendet. Die Beschichtung erfolgt üblicherweise mittels thermischer, stromloser oder elektrolytischer Beschichtung oder durch Abscheidung aus der Gasphase.

EP-A-533 444 beschreibt die Herstellung von Schleifpellets, die Schleifteilchen aus Diamant (US-A-4,770,907 und US-A-5,143,523) oder kubischem Bornitrid mit einem Überzug aus mindestens 20 Gew.-% Metall, insbesondere Kobalt, Nickel, Eisen, Kupfer, Zink und Molybdän, enthalten. Hergestellt werden diese Schleifteilchen durch Aufsprühen einer Metallpulveraufschlämmung auf in einer Wirbelschicht fluidisierte Hartstoffteilchen und anschließende Sinterung. DE-A 26 32 865 offenbart ein Verfahren zur Beschichtung von Diamantpartikeln oder Partikeln aus kubischem Bornitrid durch Aufmahlung von festen, pulverförmigen Metallverbindungen, beispielsweise den Sulfiden von Molybdän, Wolfram oder Titan oder Chromchlorid, und anschließende thermische Zersetzung unter Ausbildung eines Metallüberzugs. Nachteile dieser Verfahren sind, daß zwei Verfahrensschritte und hohe Temperaturen erforderlich sind, und daß das Ergebnis schwer steuerbar ist.

WO-A 95/26245 lehrt ein Verfahren zur Beschichtung von Hartstoffteilchen, insbesondere Wolframcarbid mit Metallen der Eisengruppe durch thermische Zersetzung von Metallsalzen, indem die Metallsalze als Komplexe eines Komplexbildners in einem organischen Lösungsmittel, das darüber hinaus eine weitere Kohlenstoffquelle und die zu beschichtenden Hartstoffteilchen enthält, gelöst werden, das organische Lösungsmittel entfernt wird und durch anschließendes Erhitzen in neutraler oder reduzierender Atmosphäre die Metallbeschichtung erzeugt wird. Dieses Verfahren ist vergleichsweise umständlich und nur anwendbar, wenn entsprechende stabile und lösliche Metallsalze zur Verfügung stehen.

Bei dem von BE-A 767 354 gelehrten Verfahren wird Metall elektrolytisch auf Hartstoffteilchen abgeschieden, wozu ein elektrochemischer Verfahrensschritt notwendig ist.

EP-A-622 425 lehrt ein Verfahren zur Abscheidung von Eisen- Kobalt- oder Nickelüberzügen auf metallischen Substraten durch Zersetzung der entsprechenden Metallcarbonyle in Gegenwart des metallischen Substrats. US 4,229,209 lehrt die Zersetzung von Eisencarbonyl in Gegenwart von goldhaltigem Gestein, wobei sich das Eisen bevorzugt auf dem metallischen Gold abscheidet, das dadurch anschließend bequem mittels Magneten abgetrennt werden kann. DE-A-44 03 678 lehrt ein Verfahren zur Abscheidung von Metallschichten auf Substraten mit oxidischen (Molybdän-, Wolfram- oder Zinnoxid) oder metallischen Oberflächen.

US-A-3,663,191 lehrt ein Verfahren zur Plasmabeschichtung von Diamantpartikeln mit Metallen in Vakuumapparaturen.

US-A-4,062,660 und CA-A-10 35 962 offenbaren ein Verfahren zur Beschichtung von Diamantpartikeln mit Metallen wie Nickel, Kobalt oder Eisen, bei dem im Anschluß an eine mit üblichen stromlosen oder elektrochemischen Verfahren durchgeführte Beschichtung von Diamantpulvern mit Metallen oder an eine Beschichtung von größeren Diamanten durch Aufpressen von Metall unter hohem Druck die metallbeschichteten Diamanten in nichtoxidierender Atmosphäre oder im Vakuum erhitzt werden.

Die bekannten Verfahren zur Beschichtung von Hartstoffen mit Metallen führen jedoch nicht immer zu befriedigenden technischen Ergebnissen oder können solche befriedigenden Ergebnisse, wenn überhaupt, nur unter Inkaufnahme eines hohen apparativen Aufwands, niedriger Produktivität und hoher Fertigungskosten erreichen. Der vorliegenden Erfindung lag daher die Aufgabe zugrunde, ein einfaches und wirtschaftliches Verfahren zur Herstellung metallbeschichteter Hartstoffe zu finden, das zudem zu technisch befriedigenden Ergebnissen führt.

Demgemäß wurde ein Verfahren zur Herstellung metallbeschichteter Hartstoffe gefunden, daß dadurch gekennzeichnet ist, daß man die Metallschicht durch Zersetzung von Metallcarbonyl in Gegenwart der Hartstoffe erzeugt. Mit diesem erfindungsgemäßen Verfahren können auf bequeme Weise metallbeschichtete Hartstoffe mit guter Haftung der Metallschicht sowie beeinflußbarer Härte und Zusammensetzung der Metallschicht mit hoher Produktivität hergestellt werden. Weiterhin wurden metallbeschichtete Hartstoffe gefunden, deren Metallschicht eine durch den Kohlenstoff- und/oder Stickstoffgehalt des Metalls gegenüber dem reinen Metall erhöhte Härte aufweist und die durch das in Anspruch 1 definierte Verfahren erhältlich sind. Insbesondere wurden derartige Hartstoffe gefunden, die mit einer Stahlschicht umhüllt sind.

Unter Hartstoffen werden im Rahmen dieser Erfindungen harte Werkstoffe verstanden, soweit sie keine elementaren Metalle oder Legierungen von Metallen sind. Hartstoffe sind beispielsweise die Carbide, Nitride, Boride und Silicide der Elemente der 4., 5. und 6. Nebengruppen des Periodensystems der Elemente, also Titan-, Zirkonium-, Hafnium-, Vanadium-, Niob-, Tantal-, Chrom- und Molybdän- -carbid, -nitrid, -borid und -silicid (die im Laborjargon gelegentlich auch als "metallische Hartstoffe" bezeichnet werden, da sie sich formal vom Metall durch Einlagerung der nichtmetallischen Elemente ableiten), Thorium- und Urancarbid, und Hartstoffe, die ausschließlich nichtmetallische Elemente enthalten, wie Bornitrid, insbesondere kubisches Bornitrid, Borcarbid, Korund, Siliciumcarbid, Siliciumnitrid und Diamant. Hartstoffe haben auf der Härteskala nach Mohs im allgemeinen eine Härte von mindestens 8, vorzugsweise von mindestens 9. Im Rahmen dieser Erfindung bevorzugte Hartstoffe sind die Carbide, Nitride, Boride und Silicide der Elemente der 4., 5. und 6. Nebengruppen des Periodensystems der Elemente, also Titan-, Zirkonium-, Hafnium-, Vanadium-, Niob-, Tantal-, Chrom- und Molybdän- -carbid, -nitrid, -borid und -silicid, kubisches Bornitrid, Borcarbid, Siliciumcarbid, Siliciumnitrid und Diamant. Besonders bevorzugt sind Titancarbid, Titannitrid, Tantalcarbid, Wolframcarbid, kubisches Bornitrid, Borcarbid, Siliciumcarbid, Siliciumnitrid und Diamant.

Die auf den Hartstoffen abzuscheidende Metallschicht besteht vorzugsweise aus Eisen, Kobalt und/oder Nickel sowie Legierungen dieser Metalle. In ganz besonders bevorzugter Form besteht die Metallschicht aus Eisen. Die Metalle können Anteile an Kohlenstoff, Stickstoff und unvermeidliche Verunreinigungen enthalten.

Das Ausgangsmaterial zur Erzeugung der Metallbeschichtung sind die Carbonyle der entsprechenden metallischen Bestandteile der Metallbeschichtung, in bevorzugter Weise Eisenpentacarbonyl, das dimere Kobalttetracarbonyl und Nickeltetracarbonyl sowie ihre Gemische. Metallcarbonyle lassen sich technisch bekanntlich etwa durch Umsetzung des feinverteilten Metalls mit Kohlenmonoxid herstellen, können zumeist durch Destillation in hohen Reinheitsgraden erhalten werden und sind teilweise gängige Handelswaren, die für verschiedene technische Zwecke, beispielsweise als Katalysatoren oder zur Reindarstellung von Metallen verwendet werden. Einen Überblick über die Technologie der Metallcarbonyle gibt beispielsweise Ullmann's Encyclopedia of Industrial Chemistry, Sixth Edition, 1998 Electronic Release (WILEY-VCH Verlag GmbH, Weinheim), unter dem Stichwort ,,Sintered Steel and Iron", dort insbesondere Abschnitt 2.1.4.:"Carbonyl Iron Powders" und dem Stichwort "Iron Compounds", dort insbesondere die Abschnitte 3.2.: "Production" und 3.5.: "Uses", sowie die dort zitierte Literatur.

Zur Reindarstellung von Metallen aus Metallcarbonylen zersetzt man die Metallcarbonyle durch Einwirkung von Lichtenergie oder -technisch einfacher - thermischer Energie nach bekannten und einfachen Verfahren, wobei sich Metalle in Form feiner Pulver abscheiden. Auf diese Weise durch Erhitzen von Eisencarbonyl hergestelltes Eisenpulver (meist als "Carbonyleisen" bezeichnet) findet beispielsweise in der Sintermetallurgie weite Verwendung. Es wurde nun gefunden, daß die thermische Zersetzung von Metallcarbonylen in Gegenwart von Hartstoffen die Erzeugung einheitlicher Metallüberzüge auf den Hartstoffen ermöglicht, und nicht etwa zur Bildung von Metallpulver neben unbeschichteten Hartstoffen führt.

Mit dem erfindungsgemäßen Verfahren ist es insbesondere auch möglich, die bekannten Methoden der Beeinflussung der Eigenschaften der durch Carbonylzersetzung hergestellten Metalle auf die Metallbeschichtung der Hartstoffe anzuwenden und so die Eigenschaften dieser Metallbeschichtung zu steuern. Beispielsweise kann durch Zersetzung eines Gemisches von Metallcarbonylen eine Legierung abgeschieden werden, und durch Zugabe von reduzierenden Gasen wie Wasserstoff kann der Kohlenstoffgehalt des abgeschiedenen metallischen Überzugs variiert werden, was speziell im Fall des Eisens einen hohen Einfluß auf die Härte des Überzugs hat. Durch Zusatz von Ammoniak, der ebenfalls den Kohlenstoffgehalt beeinflusst, kann zusätzlich der Stickstoffgehalt des metallischen Überzugs eingestellt werden, was zusätzlichen Einfluß auf die Eigenschaften des Überzugs, auch auf dessen Härte, ausübt. Insbesondere können mit dem erfindungsgemäßen Verfahren Hartstoffe mit einer harten Metallschicht umhüllt werden, insbesondere mit einer Stahlschicht (Stahl ist bekanntlich die Bezeichnung für kohlenstoffhaltiges Eisen), die durch den sich in Abhängigkeit der angewendeten Zersetzungsbedingungen einstellenden Kohlenstoff- und Stickstoffgehalt des Eisens deutlich härter ist als das mit den bekannten Verfahren abscheidbare reine Eisen.

Im allgemeinen wird im erfindungsgemäßen Verfahren ein Kohlenstoffgehalt des abgeschiedenen Metalls von 0 bis 8 Gew.-%, vorzugsweise von 0,2 bis 5 Gew.-% und in besonders bevorzugter Weise von 0,5 bis 3 Gew.-% eingestellt, und ein Stickstoffgehalt von im allgemeinen 0 bis 5 Gew.-%, vorzugsweise von 0,02 bis 4 Gew.-% und in besonders bevorzugter Weise von 0,5 bis 2 Gew.-%. Die Bestimmung des Kohlenstoffgehalts der auf den Hartstoffen abgeschiedenen Metallschicht ist im Falle von Carbiden außerordentlich schwierig, da Carbide naturgemäß Kohlenstoff enthalten, bzw. im Falle von Diamanten außerordentlich schwierig, da Diamant reiner Kohlenstoff ist, was die Messungen verfälscht, es wird jedoch angenommen, daß bei Carbonylzersetzungen in Gegenwart und in Abwesenheit von Hartstoffen (Diamanten) unter sonst gleichen Bedingungen gleiche Zusammensetzungen und Eigenschaften des abgeschiedenen Metalls erzeugt werden.

Die Dicke der abgeschiedenen Metallschicht beträgt im allgemeinen mindestens 1 nm, vorzugsweise mindestens 100 nm und in besonders bevorzugter Weise mindestens 500 nm. Sie beträgt im allgemeinen höchstens 1 mm, in bevorzugter Weise höchstens 100 µm und in besonders bevorzugter Weise höchstens 20 µm.

Im erfindungsgemäßen Verfahren werden ein oder mehrere Metallcarbonyle in Gegenwart der zu beschichtenden Hartstoffe zersetzt. Dies geschieht vorzugsweise entweder in flüssiger Phase oder aus der Gasphase.

Zur Durchführung des erfindungsgemäßen Verfahrens in der Flüssigphase wird eine Suspension der Hartstoffe in einem Suspensionsmittel, das gleichzeitig ein Lösungsmittel für das Metallcarbonyl oder die Metallcarbonyle sein kann und vorzugsweise ist, in einem Reaktionsgefäß hergestellt. Zu dieser Suspension wird die gewünschte Menge Metallcarbonyl zugesetzt und die Mischung solange erhitzt, bis eine Metallschicht der gewünschten Dicke auf den Hartstoffen abgeschieden wurde. Das Metallcarbonyl kann sowohl vollständig zu Beginn der Reaktion als auch in Portionen oder kontinuierlich während der Reaktion zugegeben werden. Vorzugsweise wird gerade soviel Metallcarbonyl verwendet, daß seine Zersetzung zur Abscheidung einer Metallschicht der gewünschten Dicke gerade ausreicht und so zum Ende der Beschichtung auch kein freies Metallcarbonyl mehr in der Mischung vorhanden ist.

Als Suspensions- und Lösungsmittel wird ein bei den Reaktionsbedingungen flüssiges inertes Lösungsmittel oder ein entsprechendes inertes Lösungsmittelgemisch verwendet. Geeignete Lösungsmittel sind etwa organische Lösungsmittel wie aliphatische, aromatische oder araliphatische Kohlenwasserstoffe und Ether, die jeweils auch substituiert sein können. Beispiele für verwendbare Lösungsmittel sind gegebenenfalls nachbehandelte Erdöldestillate (hochsiedende Benzinschnitte, "Ligroin", "Solvent Naphtha", "Solvesso®" der Exxon Chemical), teil- oder vollständig hydrierte mehrkernige Aromaten wie Dekalin oder Tetralin, Dimethyl-Ethylenglykol, -Diethylenglykol oder -Triethylenglykolether.

Die Zersetzung des Metallcarbonyls wird durch Erhitzen zum Sieden bewirkt. Vorzugsweise wird absiedendes Metallcarbonyl in einem Kühler kondensiert, falls ein niedrigsiedendes Lösungsmittel verwendet wird, gemeinsam mit diesem, und in das Reaktionsgefäß zurückgeleitet. Der Fortgang der Reaktion kann anhand des entstehenden Kohlenmonoxids verfolgt werden. Wenn ein hochsiedendes Lösungsmittel ("hochsiedend" bedeutet in diesem Zusammenhang einen höheren Siedepunkt als das Metallcarbonyl), und das Carbonyl nicht kontinuierlich, sondern in einer oder mehreren Portionen zugegeben wurde, kann das Ende der Reaktion einfach daran erkannt werden, daß kein Carbonyl mehr absiedet.

Vorzugsweise wird die Suspension während der Zersetzung mechanisch durchmischt, beispielsweise durch Rühren. Falls gewünscht, können der Reaktionsmischung zusätzliche Komponenten zur wunschgemäßen Beeinflussung der Eigenschaften des abgeschiedenen Metalls zugesetzt werden. Hier können sämtliche Techniken angewendet werden, die von der Herstellung von Reinmetallen aus Metallcarbonylen bekannt sind. Es ist bekannt, daß die Gegenwart eines reduzierenden Gases wie Wasserstoff den Kohlenstoffgehalt des abgeschiedenen Metalls absenkt, was speziell bei Eisen auch dessen Härte erniedrigt. Ist Ammoniak zugegen, so sinkt der Kohlenstoffgehalt des abgeschiedenen Metalls ebenfalls, das Metall wird jedoch in gewissem Umfang nitridiert. Sind kohlenstoffhaltige Verbindungen, beispielsweise Methan, Kohlenmonoxid und/oder Kohlendioxid zugegen, so wird der Kohlenstoffgehalt des abgeschiedenen Metalls erhöht. Die exakte Zusammensetzung der Reaktionsmischung wird daher in Abhängigkeit von den gewünschten Eigenschaften des Metallüberzugs gewählt und kann in wenigen Routineversuchen optimiert werden. Solche zusätzlichen Komponenten können der Reaktionsmischung vollständig zu Beginn der Reaktion oder in Portionen oder kontinuierlich während der Reaktion zugesetzt werden, beispielsweise kann durch die Reaktionsmischung ein Gas geleitet werden, das solche weiteren Reaktionskomponenten enthält

Die metallbeschichteten Hartstoffe können anschließend durch einfaches Filtrieren gewonnen werden. Sie können, falls nötig, frei von anhaftendem Lösungsmittel gespült werden, beispielsweise mit Alkoholen wie Methanol, Ethanol, n- oder iso-Propanol, n-, iso-, sec.- oder tert.-Butanol, Ether wie Diethylether, Di-n-Butylether, Methyl- oder Ethyl-tert.-Butylether, Methyl- oder Ethyl-tert.-Amylether, Wasser oder Gemischen davon.

Zur Durchführung des Verfahrens aus der Gasphase werden die HArtstoffe in einem beheizten Behälter vorgelegt und ein metallcarbonylhaltiger Gasstrom über sie geleitet, wobei sich ein Metallüberzug auf den Hartstoffen bildet. Als Behälter wird beispielsweise ein Rohr, vorzugsweise ein sich drehendes Drehrohr verwendet.

Durch den Behälter und über die Hartstoffe wird ein Metallcarbonyl enthaltendes Gas geleitet. Das Gas kann reines Metallcarbonyl sein, vorzugsweise wird jedoch mit Inertgas verdünntes Metallcarbonyl verwendet. Dazu wird nach bekannten Methoden ein mit Metallcarbonyl beladener Inertgasstrom hergestellt, beispielsweise in einem Sättigungs- oder Totalverdampfer. Als Inertgas wird ein unter Reaktionsbedingungen inertes Gas verwendet, beispielsweise Stickstoff, Kohlenmonoxid, Kohlendioxid, Helium, Neon oder Argon oder ein Gemisch dieser Gase. Vorzugsweise wird Stickstoff verwendet. Das über die Hartstoffe geleitete Gasgemisch kann - wie bei der Durchführung der Umsetzung in der Flüssigphase - außer Inertgas und Metallcarbonyl noch weitere Komponenten zur wunschgemäßen Beeinflussung der Eigenschaften der abgeschiedenen Metallschicht enthalten. Auch hier können sämtliche Techniken angewendet werden, die von der Herstellung von Reinmetallen aus Metallcarbonylen bekannt sind. Die exakte Zusammensetzung des über die Hartstoffe geleiteten Gasgemisches wird daher in Abhängigkeit von den gewünschten Eigenschaften des Metallüberzugs gewählt und kann in wenigen Routineversuchen optimiert werden. Im allgemeinen enthält das Gasgemisch 0 bis 50 Vol.-% Ammoniak, in bevorzugter Weise 2 bis 30 Vol.-% und in besonders bevorzugter Form 4 bis 20 Vol.-%, sowie 0 bis 50 Vol.-% Methan, in bevorzugter Weise 2 bis 30 Vol.-% und in besonders bevorzugter Form 4 bis 20 Vol.-%, mit der Maßgabe, daß sich sämtliche im Gasgemisch befindlichen Komponenten zu 100 Vol.-% addieren.

Die Zeitdauer der Behandlung der Hartstoffe mit dem über die Hartstoffe geleiteten Gasgemisch bemißt sich nach dem Metallcarbonylgehalt des Gasgemisches und der gewünschten abzuscheidenden Metallmenge. Nach Abschluß der Reaktion werden die metallbeschichteten Hartstoffe dem Drehrohr entnommen.

Die im Reaktionsgefäß - sowohl bei Durchführung des Verfahrens in der Flüssigphase als auch aus der Gasphase - einzustellende Temperatur liegt im allgemeinen bei höchstens 400 °C, vorzugsweise unter 350 °C und in besonders bevorzugter Weise unter 300 °C. Es muß jedoch mindestens eine Temperatur eingestellt werden, die zur Zersetzung des Metallcarbonyls und zur Abscheidung von Metall in befriedigender Geschwindigkeit ausreicht. Diese Temperatur ist vom verwendeten Metallcarbonyl abhängig und kann leicht in Vorversuchen ermittelt werden. Im allgemeinen liegt sie oberhalb von 100 °C. Üblicherweise wird die Metallabscheidung nach höchstens 10 Stunden beendet sein, zumeist nach höchstens 5 Stunden.

### Beispiele

### Beispiele 1 bis 4

In einem mittels eines Ölbads beheizten Glas-Rundkolben, ausgestattet mit Rührer, Rückflußkühler, Temperaturfühler sowie Gaszuleitung und -ableitung wurden unter Stickstoffatmosphäre Diamantpartikel in Tetrahydronaphthalin ("Tetralin") vorgelegt. Zu dieser Suspension von Diamantpartikeln wurde Eisenpentacarbonyl Fe(CO)₅ zugegeben und die Mischung auf 150-170°C erhitzt. Dabei siedete das Fe(CO)₅ am Rückfluß, und gasförmiges Kohlenmonoxid entwich. Die während der Reaktion entweichende Gasmenge wurde mittels einer Gasuhr gemessen, diese Menge ist ein Maß für den Reaktionsfortschritt.

Nachdem kein aus dem Rückflußkühler ablaufendes Eisenpentacarbonyl-Kondensat mehr zu beobachten und die anhand des eingesetzten Eisenpentacarbonyls zu erwartende Menge an Kohlenmonoxid freigesetzt worden war, wurde die Heizung des Kolbens entfernt. Nach Abkühlung wurden der Inhalt des Kolbens abfiltriert und der feste Rückstand mit Ethanol gewaschen und untersucht. Weitere Versuchsparameter sind in Tabelle 1 aufgeführt.

Der feste Rückstand bestand aus eisenbeschichteten Diamanten. In Vergleichsversuchen wurde festgestellt, daß der feste Rückstand dann, wenn deutlich größere Mengen an Eisencarbonyl eingesetzt wurden neben eisenbeschichteten Diamanten auch diamantfreie Carbonyleisenpartikel enthielt.

Die eisenbeschichteten Diamanten wurden mittels mikroskopischer Aufnahmen begutachtet und die Homogenität der Beschichtung und ihre Haftung beurteilt. Als Homogenität wurde dabei beurteilt, ob eine geschlossene Eisenschicht über die Oberfläche der Diamanten verteilt war, und als Haftung, ob diese Eisenschicht schlüssig auf dem Diamanten auflag oder ganz oder teilweise keinen Kontakt zur Diamantoberfläche hatte. Zur Bewertung der mechanischen Belastbarkeit wurden die beschichteten Diamantpartikel anschließend in Ethanol dispergiert, 15 Minuten lang in einem üblichen Labor-Ultraschallbad beschallt und anschließend abfiltriert und getrocknet; danach wurde erneut die Haftung durch mikroskopische Begutachtung beurteilt. Die Ergebnisse sind in Tabelle 2 zusammengefaßt.

### Beispiele 5 bis 8

In einem mittels eines Heißluftgebläses beheizten Glas-Drehrohr, ausgestattet mit Temperaturfühler sowie Gaszuleitung und -ableitung wurden unter Stickstoffatmosphäre Diamantpartikel vorgelegt.

In einem Vorlagegefäß (Zweihals-Braunglaskolben) wurde Eisenpentacarbonyl eingewogen. Durch dieses Gefäß wurde ein Stickstoffstrom geleitet, so daß ein gemäß dem Dampfdruck des Eisenpentacarbonyls mit Eisenpentacarbonyl gesättigter Stickstoffstrom erzeugt wurde. Dieser Stickstoffstrom wurde in das mit Diamanten beschickte und vorgeheizte Drehrohr eingeleitet, wodurch sich das Eisenpentacarbonyl im Drehrohr zersetzte. In Beispiel 8 enthielt der in die Vorlage eingeleitete Stickstoffstrom zusätzlich Ammoniak.

Nach Einleitung der gewünschten Menge Eisenpentacarbonyl wurde die Zufuhr von Eisenpentacarbonyl und die Heizung abgestellt und der Inhalt des Drehrohrs unter Stickstoffatmosphäre abgekühlt. Danach wurde der aus eisenbeschichteten Diamanten bestehende feste Rückstand untersucht. Weitere Versuchsparameter sind in Tabelle 3 aufgeführt.

Die eisenbeschichteten Diamanten wurden mittels mikroskopischer Aufnahmen begutachtet und die Homogenität der Beschichtung und ihre Haftung beurteilt. Als Homogenität wurde dabei beurteilt, ob eine geschlossene Eisenschicht über die Oberfläche der Diamanten verteilt war, und als Haftung, ob diese Eisenschicht schlüssig auf dem Diamanten auflag oder ganz oder teilweise keinen Kontakt zur Diamantoberfläche hatte. Zur Bewertung der mechanischen Belastbarkeit wurden die beschichteten Diamantpartikel anschließend in Ethanol dispergiert, 15 Minuten lang in einem üblichen Labor-Ultraschallbad beschallt und anschließend abfiltriert und getrocknet; danach wurde erneut die Haftung durch mikroskopische Begutachtung beurteilt. Die Ergebnisse sind in Tabelle 4 zusammengefaßt.

Die Behandlung mit Ultraschall ist eine mechanisch außerordentlich hohe Belastung für die Beschichtung. Die Tatsache, daß in manchen oder den meisten Fällen sich die Beschichtung ablöste, zeigt also nicht, daß die Beschichtung wenig haltbar ist, sondern die Tatsache, daß die Beschichtung sich nicht in allen Fällen ablöste, zeigt, daß die Beschichtung außerordentlich gut haftet. Die Beispiele zeigen daher insgesamt, daß mit dem erfindungsgemäßen Verfahren sehr einfach metallbeschichtete Diamanten hergestellt werden können.

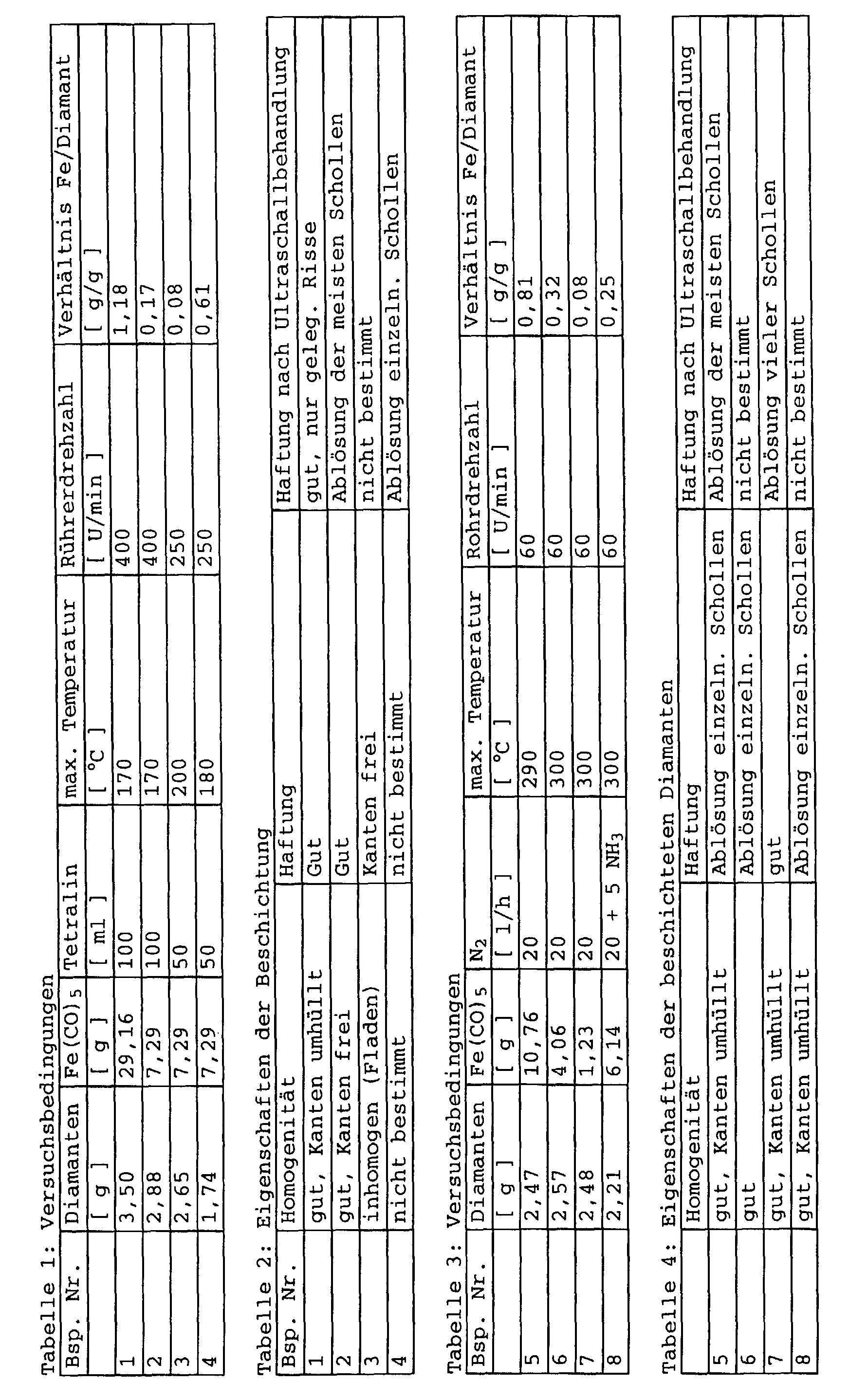

## Patentansprüche

1. Verfahren zur Herstellung metallbeschichteter Hartstoffe, dadurch gekennzeichnet, daß man die Metallschicht durch Zersetzung von Metallcarbonyl in Gegenwart der Hartstoffe erzeugt.

2. Verfahren nach Anspruch 1, dadurch gekennzeichnet, daß man Metallcarbonyl thermisch zersetzt.

3. Verfahren nach Anspruch 2, dadurch gekennzeichnet, daß man Metallcarbonyl durch Zersetzung in einer Suspension der Hartstoffe auf diesen abscheidet.

4. Verfahren nach Anspruch 2, dadurch gekennzeichnet, daß man Metallcarbonyl aus der Gasphase über Hartstoffen auf diesen abscheidet.

5. Verfahren nach Anspruch 4, dadurch gekennzeichnet, daß man Metallcarbonyl in Gegenwart von Wasserstoff, Methan und/oder Ammoniak zersetzt.

6. Verfahren nach den Ansprüchen 1 bis 5, dadurch gekennzeichnet, daß man als Metallcarbonyl Eisenpentacarbonyl verwendet und eisenbeschichtete Hartstoffe herstellt.

7. Metallbeschichtete Hartstoffe, deren Metallschicht eine durch den Kohlenstoff- und/oder Stickstoffgehalt des Metalls gegenüber dem reinen Metall erhöhte Härte aufweist, erhältlich durch das in Anspruch 1 definierte Verfahren.

8. Stahlbeschichtete Hartstoffe.
